# EUROPEAN PATENT SPECIFICATION

(11) **EP 2 816 880 B1**
(45) Date of publication and mention of the grant of the patent: **23.03.2016**
(21) Application number: 13305833.9
(22) Date of filing: 20.06.2013
(51) Int. Cl.: H05K 7/20

(54) **Anti-recirculation device for modular fan tray arrangements**
Umwälzungsschutzvorrichtung für modulare Lüftereinsatzanordnungen
Dispositif destiné à empêcher la recirculation modulaire pour des agencements de plateau de ventilateur

(43) Date of publication of application: 24.12.2014
(73) Proprietor: ALCATEL LUCENT, 92100 Boulogne-Billancourt (FR)
(72) Inventor: Seitz, Reinhold, 91161 Hilpoltstein (DE)
(74) Representative: Shamsaei Far, Hassan

(56) References cited:
- DE-A1- 4 207 531
- US-A1- 2008 192 429
- US-B1- 6 407 918

## Description

The present invention relates to an anti-recirculation device for preventing outgoing forced airflow to recirculate in an electronic cabinet during removing operation of a fan tray module provided at an air outlet of said cabinet.

Nowadays, electronic equipment especially telecommunication equipment have a densely packaged design which needs an extraordinary high forced cooling air flow rate provided by the fan tray module. The main technical problem to be solved by an anti-recirculation device is to avoid recirculation of hot air in electronic equipment of the cabinet in case of replacement or maintenance of the fan tray module. Any failure of the fan tray module requiring the replacement of the latter will degrade the cooling performance significantly and hence countermeasures need to be taken. Indeed, the slot left empty by the removed fan tray module at the air outlet creates a pressure drop and recirculation of hot air into the electronic cabinet.

Due to higher packaging density of nowadays electronic systems, these systems need more and more forced air flow cooling with high air flow volume and high pressure built-up across the air flow in the system. Many systems use modular fan tray arrangements, also called fan tray modules, so that in case of a fan motor failure only one module but not a complete overall fan tray needs to be replaced. The replacement of an overall fan tray module must be done in such a short time frame that it is practically not possible. The replacement of just a fan tray module still guarantees proper airflow, however, recirculation of hot air and pressure drop must be avoided. The hot air at the air outlet area of the system will be pressed back into the system if a fan tray module would be removed and hence this will cause overheating and thermal damages to components.

It has to be noted that the fan tray module preferably comprises several fans, each with a fan motor and able to force the outgoing airflow to the air outlet. Current designs use anti-recirculation flaps or louvers per fan directly attached to the fan motors.

The louvers or rubber flaps per fan are a good solution to prevent circulation of air when the fan is not activated, e.g. in case of failure of the fan motor. However, these louvers and flaps being permanently in the air flow they add additional air flow impedance which needs to be overcome by higher fan performance and hence higher energy consumption.

Furthermore, these parts, especially in case of rubber flaps, contribute significantly to the acoustic noise emission of the overall system pressure drop and hence permitted limits for product compliance may be violated.

An objective of the present invention is to provide an anti-recirculation device able to avoid recirculation of hot air in the electronic cabinet in case of replacement or maintenance of the fan tray module.

According to a characterizing embodiment of the invention, this objective is achieved due to the fact that said fan tray module is adapted to be removed from said electronic cabinet by sliding along fan guide rails, and that said anti-recirculation device comprises a roller blind having a blind end bar adapted to be coupled to a rear edge of said fan tray module and adapted to slide along blind guide rails pulled by said fan tray module whereby the roller blind closes the empty slot created by said fan tray module.

In this way, the roller blind takes the place of the fan tray module when this fan tray module is removed or pulled out from the electronic cabinet. As a result, a pressure drop is avoided and especially the recirculation of hot air back into the electronic equipment, e.g. subrack, of the electronic cabinet is blocked.

Moreover, the roller blind adds no airflow impedance to the system and does not contribute to acoustic noise of the system.

The present anti-recirculation device with its roller blind is thus a cheap design with a huge benefit compared to current solutions, e.g. rubber flaps or louvers, to overcome pressure drop and to avoid recirculation of hot air in any electronic equipment with forced air cooling.

It is to be noted that the US Patent US-6 407 918-B1 (EDMUNDS, HOWARD ROSS [US] ET AL) published on 18 June 2002 discloses an apparatus and method for providing a supply of air to cool electrical devices is provided. The apparatus comprises a two fan housings, each containing a number of fans arranged to blow air in a parallel fashion. The exhaust of one housing is connected to the intake of the other housing by a balancing plenum. The apparatus provides a sufficient supply of cooling air when one or more of the fans is inoperable. The device being cooled may be the power bridge of an exciter for a power generation system. A method for providing a supply of air to electrical devices is also provided.

It is also to be noted that the US Patent Application US-2008/192429-A1 (WOOLSEY TERRILL [US] ET AL) published on 14 August 2008 discloses embodiments of a multi-fan cooling system in which redundancy in airflow across a plurality of electrical boards is maintained. This redundancy is provided by having an ability to at least partially divert airflow from a functioning fan to an electrical board for which its corresponding fan has failed. According to various embodiments of the present invention, the multi-fan cooling system comprises two fans located proximate to each other. An airflow plenum couples and distributes air from the two fans across a plurality of electrical boards. In certain embodiments, the plenum comprises stacked outlets that distribute airflow from the two fans across the plurality of electrical boards. During normal operation, this airflow is approximately evenly distributed across the electrical boards. However, if one of the fans fails, the plenum causes air from the single operating fan to still be distributed across the plurality of electrical boards. In one embodiment of the invention, the plenum includes a flap that covers an opening for the failed fan to prevent recirculation of airflow back into the failed fan.

It is finally to be noted that the German Patent Application DE-42 07 531-A1 (HANS REICHLE) published on 24 September 1992 discloses an assembly group bearers (3) wherein are inserted several fibre-glass end closure cassettes and/or cable reserve cassettes. Laterally to the individual pivot frame (2) and centrally between several such frames, is a shunt excess length space (7) formed by vertical columns. Each individual pivot frame (2) is linked via means (11) to its upper and lower corners on the main cabinet frame (1) directly next to the shunt excess length space (7). On the inside of the cabinet, on the rear side of the individual pivot frame is a grid (9) for fixation of the cables. The complete shunt front of the distributor cabinet system is closable by a vertical roller blind system (12). Each assembly group bearer (3) has parallel guide rail pairs for accommodation of end closure cassettes or cable reserve cassettes.

However, none of these known documents discloses the advantageous characteristic features of the present invention.

Another characterizing embodiment of the present invention is that said rear edge is adapted to be decoupled from said blind end bar when said fan tray module is removed from said electronic cabinet.

The removed fan tray module can then be repaired outside and away from the electronic cabinet while the roller blind closes the slot left empty by the fan tray module, preventing thereby hot air recirculation.

Also another characterizing embodiment of the present invention is that said anti-recirculation device further comprises a roller blind storage chamber provided with a spring-loaded axis mechanism adapted to pull back and roll-up said roller blind into said roller blind storage chamber, preferably when said blind end bar is coupled to said rear edge and when said fan tray module is inserted in said electronic cabinet by sliding along said fan guide rails.

In this way, the roller blind winds up automatically as supported by the spring-loaded axis mechanism. As a result, when not used, the roller blind is stored in the roller blind storage chamber, i.e. outside of the air flow cross-section.

In a preferred characterizing embodiment of the present invention, said blind end bar comprises hooks of a first type adapted to be engaged in holes provided on first taps at said rear edge of the fan tray module for coupling said blind end bar to said fan tray module. The blind end bar preferably also comprises at least one hook of a second type adapted to be engaged in a hole provided on the chassis of said electronic cabinet. The rear edge is then provided with at least one second tap adapted to release said hook of second type from said chassis.

In this way, the roller blind is connected to the fan tray module via a self-operating mechanical locking mechanism and hence closed or opened while extracting or inserting the fan tray module.

As already mentioned, the roller blind shall be closed or opened via the fan tray module during extraction or insertion of the latter. This is achieved owing to the hooks provided at the front end of the connection bar or blind end bar of the roller blind. These hooks - or other means, e.g. magnets - engage or disengage from the fan tray module respectively subrack chassis depending on the position of the blind end bar.

For instance, when the fan tray module is outside the electronic cabinet, the roller blind has closed the empty slot of the fan tray module by means of its blind end bar of which the hooks of second type are engaged in holes of the subrack chassis.

It has to be noted that the hooks and holes may be replaced by other means, e.g. magnets, on the blind end bar, rear edge and chassis.

Yet another characterizing embodiment of the present invention is that said electronic cabinet comprises a plurality of fan tray modules.

This allows mitigating the thermal impact on the electronic equipment of the electronic cabinet in case of replacement of one fan tray module of the plurality. Here again, any closed roller blind stops airflow and avoids recirculation from adjacent fan tray modules.

Again another characterizing embodiment of the present invention is that said blind guide rails are said fan guide rails.

The roller blind may have a modular design that can be adjusted to the dimensions of the fan tray module.

Further characterizing embodiments of the present anti-recirculation device are mentioned in the appended claims.

It has to be noticed that the terms "comprising" or "including", used in the claims, should not be interpreted as being restricted to the means listed thereafter. Thus, the scope of an expression such as "a device comprising means A and B" should not be limited to an embodiment of a device consisting only of the means A and B. It means that, with respect to embodiments of the present invention, A and B are essential means of the device.

Similarly, it has to be noticed that the term "coupled", also used in the claims, should not be interpreted as being restricted to direct connections only. Thus, the scope of the expression such as "a device A coupled to a device B" should not be limited to embodiments of a device wherein an output of device A is directly connected to an input of device B. It means that there may exist a path between an output of A and an input of B, which path may include other devices or means.

The above and other objectives and features of the invention will become more apparent and the invention itself will be best understood by referring to the following description of an embodiment taken in conjunction with the accompanying drawings wherein:
Fig.1 shows an anti-recirculation device according to the invention, forming part of an electronic cabinet EC with at least two fan tray modules FM to create a airflow AF and with an open roller blind BL that is fully out of the way of the airflow and has no impact on air flow impedance,
**Fig. 2** shows the anti-recirculation device of **Fig. 1** with one of the fan tray modules FM removed and with a closed roller blind BL that stops airflow AF and avoids recirculation from adjacent fan tray modules (not shown),
**Fig. 3** represents an end bar BE of the roller blind BL of the **Figs. 1 and 2** and taps TP1 with holes at a rear edge of the fan tray module FM as well as on the chassis CH of the electronic cabinet EC for coupling the blind end bar thereto,
**Fig. 4** represents the fan tray module FM with the taps TP1 of **Fig. 3** at its rear edge RE,
**Fig. 5** represents the anti-recirculation device of **Fig. 1** with an open roller blind BL and the fan tray module FM through which forced air then flows, and
**Fig. 6** represents the anti-recirculation device with a partially closed roller blind BL and the fan tray module FM partially removed from the electronic cabinet EC.

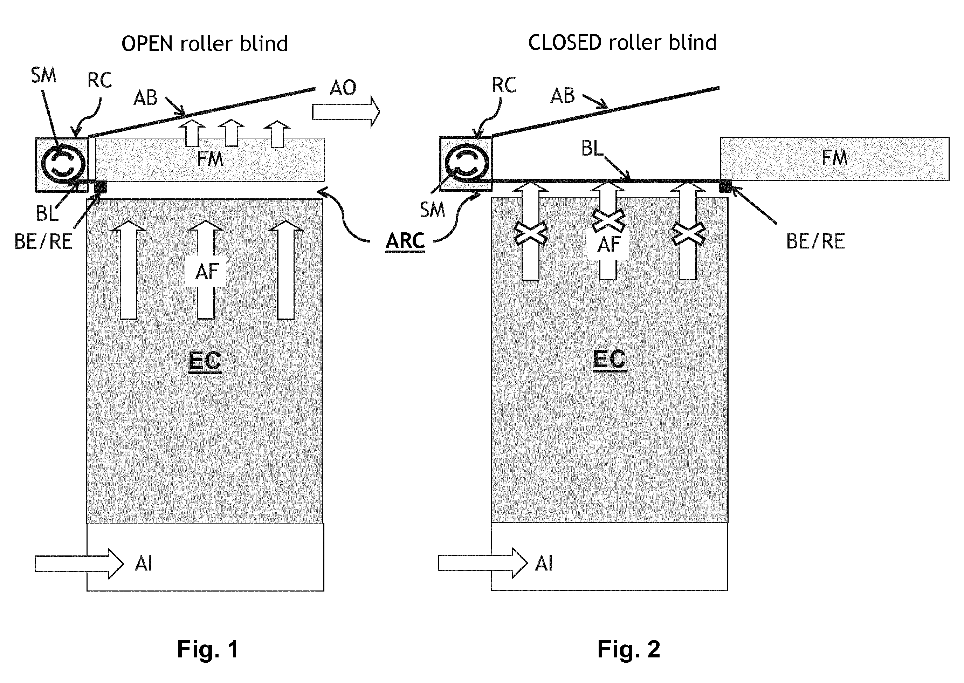

The electronic cabinet EC represented at the **Figs. 1** and **2** comprises a frame or chassis and subracks housing, for instance, telecommunication equipment. This electronic cabinet EC is provided with a forced air circulation system with an air inlet Al at the bottom of the cabinet and an air outlet AO at the top of the cabinet.

In normal operation, at least one fan tray module FM is located at the top of the electronic cabinet EC as shown at **Fig. 1****.** The fan tray module FM comprises at least one fan that forces an airflow AF from the air inlet Al to the air outlet AO, i.e. from bottom to top, through the cabinet EC. At the air outlet AO, the outgoing airflow is preferably deflected by means of an air baffle AB. The fan tray module FM can be removed, e.g. maintenance reasons, from the electronic cabinet EC by sliding along fan guide rails as will be explained later.

An anti-recirculation device ARC is also provided at the top of the electronic cabinet EC. This anti-recirculation device ARC comprises a roller blind storage chamber RC with a spring-loaded axis mechanism SM for accommodating a roller blind BL.

The roller blind BL has a blind end bar BE able to be coupled to a rear edge RE of the fan tray module FM.

At **Fig. 1**, the anti-recirculation device ARC is shown with an open roller blind. This means that the fan tray module FM covers the electronic cabinet EC and generates the airflow AF, whilst the roller blind BL is rolled-up and stored in the roller blind storage chamber RC.

At **Fig. 2**, the anti-recirculation device ARC is shown with a closed roller blind. The fan tray module FM is then removed from the electronic cabinet EC and replaced over the so created empty slot by the roller blind BL. Any airflow AF is thereby prevented to flow towards the air outlet AO.

Additionally, any airflow generated, e.g., by fan tray modules adjacent to the fan tray module FM is also prevented by the roller blind BL to re-circulate into the open area of the removed fan tray FM.

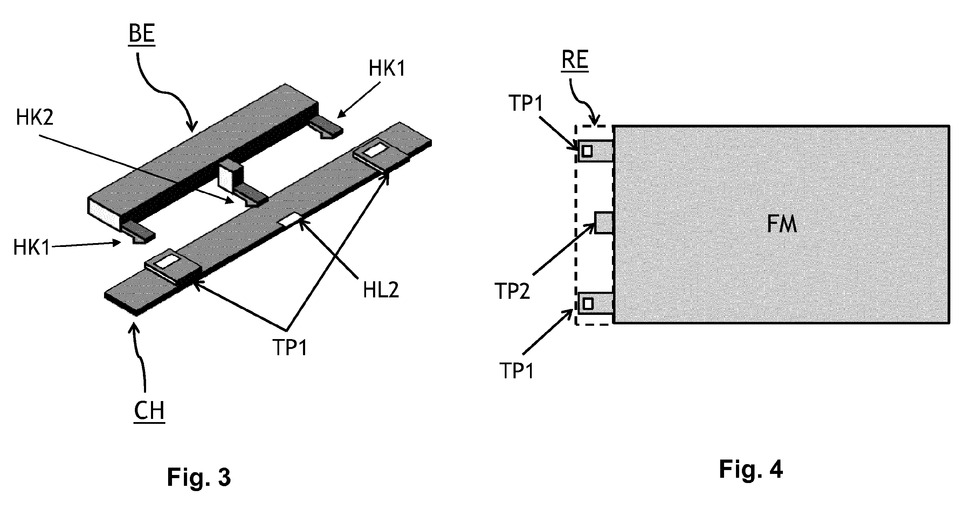

The blind end bar BE of the roller blind BL as well as the rear edge RE of the fan tray module FM are represented in more detail at **Fig. 3****.**

The blind end bar BE comprises hooks of a first type HK1 that can be engaged in holes or cut-outs provided on taps TP1 at the bottom rear edge RE of the fan tray module FM. The blind end bar BE also comprises at least one hook of a second type HK2 that can be engaged in a hole or cut-out HL2 of the chassis CH of the electronic cabinet EC.

The bottom rear edge RE of the fan tray module FM is shown in more detail at **Fig. 4**, where the taps TP1 are represented as well as a second tap TP2 used to release the hook of second type HK2 from the chassis CH when the fan tray module FM is inserted in the cabinet EC.

Owing to these hooks, taps and holes, the blind end bar BE can be automatically coupled to and decoupled from either the fan tray module FM via its rear edge RE, or the chassis CH of the electronic cabinet EC when the roller blind BL is closed.

It has to be noted that using hooks for engagement and disengagement is just an option. Other methods, e.g. magnets, can also be applied for opening or closing the roller blind BL.

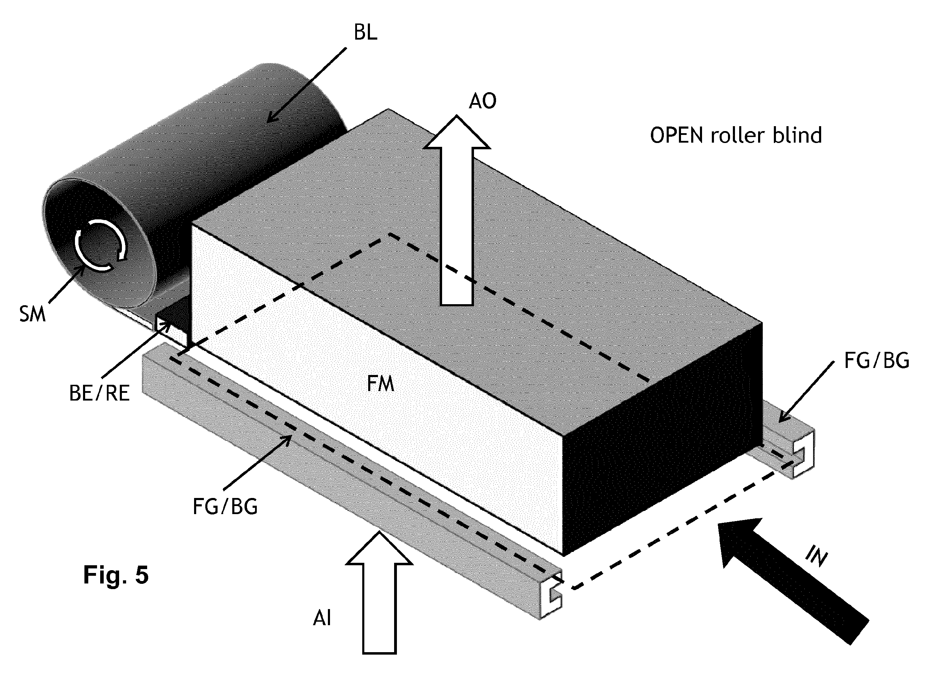

The anti-recirculation device with an open roller blind BL is shown in more detail at **Fig. 5**. The spring-loaded axis mechanism SM then has pulled and rolled-up the roller blind BL of which the blind end bar BE is coupled to the rear edge RE of the fan tray module FM by means of the hooks HK1 and taps TP1.

As already mentioned above with respect to **Fig. 1**, the fan tray module FM covers the electronic cabinet EC and generates the airflow AF from air inlet Al to air outlet AO. To this end, the fan tray module FM preferably comprises several fans, each fan having a fan motor and being able to force outgoing airflow towards air outlet AO. Each fan may also be provided with louvers to prevent recirculation of air when this fan is not activated.

It has further to be noted that the electronic cabinet EC generally comprises more than one fan tray module similar to the fan tray module FM. In such a modular fan tray arrangement there shall be a roller blind applied per fan tray module so that pressure drop is avoided and especially the recirculation of hot air back into the electronic equipment, e.g. subrack, is blocked in case of a defect fan tray module needs to be removed. The corresponding roller blind shall be closed or opened via its coupling with the fan tray module during extraction or insertion of the latter.

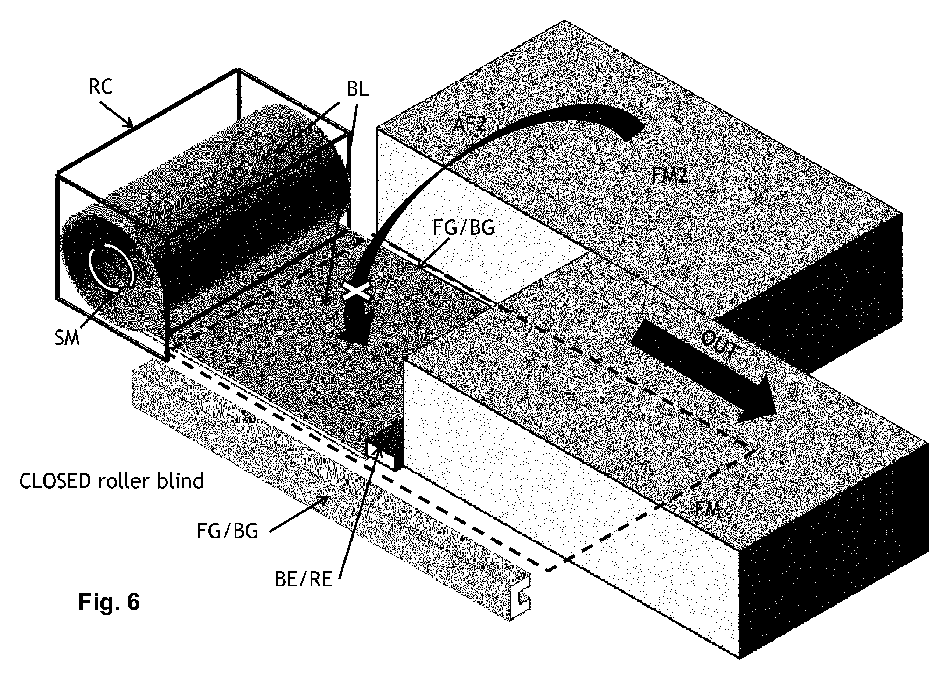

The anti-recirculation device with a partially closed roller blind BL and the coupled fan tray module FM partially removed from the electronic cabinet EC is shown in more detail at **Fig. 6**. Another fan tray module FM2, adjacent to the fan tray module FM, is also shown at **Fig. 6**.

During the removing operation OUT of the fan tray module FM from the electronic cabinet EC, the fan tray module FM slides along supporting left and right side fan guide rails FG located at both sides of the module FM.

Owing to its coupling to the blind end bar BE of the roller blind BL via its rear edge RE and the taps TP1 thereof, the fan tray module FM pulls the roller blind BL over the slot left empty by the removed fan tray module FM.

As a result, when the fan tray module FM is extracted OUT from the electronic cabinet EC, as shown at **Fig. 2**, the closed roller blind BL covers the whole slot left empty by the removed fan tray module FM and recirculation of air into the electronic cabinet EC is prevented.

During the removing operation of the fan tray module FM, the pulled roller blind BL, previously stored in the roller blind storage chamber RC, is unrolled of the spring-loaded axis mechanism SM and slides along supporting left and right side blind guide rails BG. In a preferred variant embodiment, the blind guide rails BG may be the fan guide rails FG.

It clearly appears that when the fan tray module FM is removed, even partially, from the electronic cabinet EC the roller blind BL prevents any air circulation, as the airflow AF or any other airflow as AF2 generated by an adjacent fan tray module such as FM2, though the slot left empty by the fan tray module FM.

Referring again to the **Figs. 3** and **4**, when the removed fan tray module FM is at the exit of the electronic cabinet EC, the roller blind BL is decoupled from the fan tray module FM and is coupled to the chassis CH to prevent it to be opened by the action of the pulling spring-loaded axis mechanism SM. To this end, the hooks HK1 of the blind end bar BE of the roller blind BL are disengaged from the cut-outs or holes in the taps TP1 of the bottom rear edge RE of the fan tray module FM, while the hook HK2 of the blind end bar BE is engaged in the hole HL2 of the chassis CH of the electronic cabinet EC.

When the fan tray module FM is inserted in the electronic cabinet EC, the tap TP2 of the bottom rear edge RE of the fan tray module FM disengages the hook HK2 from the hole HL2 of the chassis CH of the electronic cabinet EC, while the hooks HK1 of the blind end bar BE of the roller blind BL are engaged in the holes of the taps TP1 of the bottom rear edge RE of the fan tray module FM.

During the insertion operation of the fan tray module FM, as indicated by the arrow IN at **Fig. 5**, the roller blind BL slides along the blind guide rails BG and is rolled-up and stored into the roller blind storage chamber RC by the spring-loaded axis mechanism SM. The coupled fan tray module FM slides along the fan guide rails FG. At the end, the open roller blind BL stored in the small the roller blind storage chamber RC is fully out of the way of the airflow. The air flow has hence no obstacle in its way and air flow impedance and acoustic noise are both not negatively impacted.

It has finally to be noted that the roller blind BL can be made by different materials that just need to withstand the pressure of a closed slot of a fan tray module FM. The roller blind material can be an area of fabric or a curtain and the roller blind can also be made of metal or plastic blades. The roller blind may also be used as a anti-dust filter.

A final remark is that embodiments of the present invention are described above in terms of functional blocks. From the functional description of these blocks, given above, it will be apparent for a person skilled in the art of designing electronic devices how embodiments of these blocks can be manufactured with well-known electronic components. A detailed architecture of the contents of the functional blocks hence is not given.

While the principles of the invention have been described above in connection with specific apparatus, it has to be clearly understood that this description is merely made by way of example and not as a limitation on the scope of the invention, as defined in the appended claims.

## Claims

1. An anti-recirculation device (ARC) for preventing outgoing forced airflow (AF) to recirculate in an electronic cabinet (EC) during removing operation of a fan tray module (FM) provided at an air outlet (AO) of said cabinet,
***characterized in that*** said fan tray module (FM) is adapted to be removed from said electronic cabinet (EC) by sliding along fan guide rails (FG),
***and in that*** said anti-recirculation device (ARC) comprises a roller blind (BL) having a blind end bar (BE) adapted to be coupled to a rear edge (RE) of said fan tray module and adapted to slide along blind guide rails (BG) pulled by said fan tray module whereby the roller blind (BL) closes the empty slot created by said fan tray module (FM).

2. The anti-recirculation device according to claim **1**, ***characterized in that*** said rear edge (RE) is adapted to be decoupled from said blind end bar (BE) when said fan tray module is removed (OUT) from said electronic cabinet (EC).

3. The anti-recirculation device according to claim **1**, ***characterized in that*** said anti-recirculation device (ARC) further comprises a roller blind storage chamber (RC) provided with a spring-loaded axis mechanism (SM) adapted to pull back and roll-up said roller blind (BL) into said roller blind storage chamber (RC).

4. The anti-recirculation device according to claim **3**, ***characterized in that*** said spring-loaded axis mechanism (SM) is adapted to pull back said roller blind (BL) into said roller blind storage chamber (RC) when said blind end bar (BE) is coupled to said rear edge (RE) and when said fan tray module (FM) is inserted (IN) in said electronic cabinet (EC) by sliding along said fan guide rails (FG).

5. The anti-recirculation device according to claim **1**, ***characterized in that*** said blind end bar (BE) comprises hooks of a first type (HK1) adapted to be engaged in holes provided on first taps (TP1) at said rear edge (RE) for coupling said blind end bar (BE) to said fan tray module (FM).

6. The anti-recirculation device according to claim **5**,
***characterized in that*** said blind end bar (BE) comprises at least one hook of a second type (HK2) and adapted to be engaged in an hole (HL2) provided on the chassis (CH) of said electronic cabinet (EC),
***and in that*** said rear edge (RE) is further provided with at least one second tap (TP2) adapted to release said hook of second type (HK2) from said chassis (CH).

7. The anti-recirculation device according to claim **1**, ***characterized in that*** said fan tray module (FM) comprises a plurality of fans, each with a fan motor and adapted to force said outgoing airflow (AF) to said air outlet (AO).

8. The anti-recirculation device according to claim **7**, ***characterized in that*** each fan of said plurality are provided with louvers to prevent circulation of air when said fan is not activated.

9. The anti-recirculation device according to claim **1**, ***characterized in that*** said electronic cabinet (EC) comprises a plurality of fan tray modules (FM; FM2).

10. The anti-recirculation device according to claim **1**, ***characterized in that*** said blind guide rails (BG) are said fan guide rails (FG).

## Patentansprüche

1. Antirücklaufvorrichtung (ARC), um einen Zwangsabluftstrom (AF) daran zu hindern, in einen Elektronikschrank (EC) beim Entfernungsvorgang eines Lüfterfachmoduls (FM), das an einem Luftauslass (AO) des besagten Schranks angebracht ist, zurückzulaufen,
***dadurch gekennzeichnet, dass*** besagtes Lüfterfachmodul (FM) angepasst ist, um aus besagtem Elektronikschrank (EC) durch Schieben entlang von Lüfterführungsschienen (FG) entfernt zu werden,
***und dadurch, dass*** besagte Antirücklaufvorrichtung (ARC) einen Rollladen (BL) mit einer Rolloendleiste (BE) umfasst, die angepasst ist, um an eine hintere Kante (RE) des besagten Lüfterfachmoduls gekoppelt zu werden, und die angepasst ist, um entlang von Rolloführungsschienen (BG) zu gleiten, gezogen von besagtem Lüfterfachmodul, wobei der Rollladen (BL) den leeren Schlitz schließt, der von besagtem Lüfterfachmodul (FM) erzeugt wird.

2. Antirücklaufvorrichtung nach Anspruch ***1***, ***dadurch gekennzeichnet, dass*** besagte hintere Kante (RE) angepasst ist, um von besagter Rolloendleiste (BE) entkoppelt zu werden, wenn besagtes Lüfterfachmodul von besagtem Elektronikschrank (EC) entfernt wird (OUT).

3. Antirücklaufvorrichtung nach Anspruch ***1***, ***dadurch gekennzeichnet, dass*** besagte Antirücklaufvorrichtung (ARC) weiterhin eine Rollladen-Lagerkammer (RC) umfasst, die mit einem gefederten Achsmechanismus (SM) ausgestattet ist, der angepasst ist, um besagten Rollladen (BL) in besagte Rollladen-Lagerkammer (RC) zurückzuziehen und aufzurollen.

4. Antirücklaufvorrichtung nach Anspruch ***3***, ***dadurch gekennzeichnet, dass*** besagter gefederte Achsmechanismus (SM) angepasst ist, um besagten Rollladen (BL) in besagte Rollladen-Lagerkammer (RC) zurückzuziehen, wenn besagte Rolloendleiste (BE) an besagte hintere Kante (RE) gekoppelt wird und wenn besagtes Lüfterfachmodul (FM) in besagten Elektronikschrank (EC) durch Schieben entlang der besagten Lüfterführungsschienen (FG) eingefügt wird (IN).

5. Antirücklaufvorrichtung nach Anspruch ***1, dadurch gekennzeichnet*, *dass*** besagte Rolloendleiste (BE) Haken einer ersten Art (HK1) umfasst, die angepasst sind, um in Löcher eingefügt zu werden, die auf ersten Abzweigungen (TP1) an der besagten hinteren Kante (RE) bereitgestellt sind, um besagte Rolloendleiste (BE) an besagtes Lüfterfachmodul (FM) zu koppeln.

6. Antirücklaufvorrichtung nach Anspruch **5**,
***dadurch gekennzeichnet*, dass** besagte Rolloendleiste (BE) mindestens einen Haken einer zweiten Art (HK2) umfasst, der angepasst ist, um in ein Loch (HL2) eingefügt zu werden, das am Gestell (CH) des besagten Elektronikschranks (EC) bereitgestellt ist,
***und dadurch, dass*** besagte hintere Kante (RE) weiterhin mit mindestens einer zweiten Abzweigung (TP2) ausgestattet ist, die angepasst ist, um besagten Haken der zweiten Art (HK2) von besagtem Gestell (CH) zu lösen.

7. Antirücklaufvorrichtung nach Anspruch ***1**, **dadurch gekennzeichnet, dass*** besagtes Lüfterfachmodul (FM) eine Vielzahl von Lüftern umfasst, jeweils mit einem Lüftermotor und angepasst, um besagten Abluftstrom (AF) zum besagten Luftauslass (AO) zu treiben.

8. Antirücklaufvorrichtung nach Anspruch ***7**, **dadurch gekennzeichnet, dass*** jeder Lüfter der besagten Vielzahl mit Klappen ausgestattet ist, um einen Luftumlauf zu verhindern, wenn besagter Lüfter nicht aktiviert ist.

9. Antirücklaufvorrichtung nach Anspruch ***1**, **dadurch gekennzeichnet, dass*** besagter Elektronikschrank (EC) eine Vielzahl von Lüfterfachmodulen (FM; FM2) umfasst.

10. Antirücklaufvorrichtung nach Anspruch ***1, dadurch gekennzeichnet, dass*** besagte Rolloführungsschienen (BG) besagte Lüfterführungsschienen (FG) sind.

## Revendications

1. Dispositif destiné à empêcher la recirculation (ARC) pour empêcher un flux d'air (AF) forcé sortant de circuler à nouveau dans une armoire électronique (EC) durant l'opération de retrait d'un module de plateau de ventilateur (FM) prévu à une sortie d'air (AO) de ladite armoire,
***caractérisé en ce que*** ledit module de plateau de ventilateur (FM) est adapté pour être retiré de ladite armoire électronique (EC) en coulissant le long de rails de guidage de ventilateur (FG),
***et en ce que*** ledit dispositif destiné à empêcher la recirculation (ARC) comprend un store à enroulement (BL), présentant une barre terminale de store (BE) adaptée pour être connectée à un bord arrière (RE) dudit module de plateau de ventilateur et adaptée pour coulisser le long de rails de guidage de store (BG), tirée par ledit module de plateau de ventilateur, le store à enroulement (BL) fermant ainsi la fente vide créée par ledit module de plateau de ventilateur (FM).

2. Dispositif destiné à empêcher la recirculation selon la revendication 1, ***caractérisé en ce que*** ledit bord arrière (RE) est adapté pour être déconnecté de ladite barre terminale de store (BE) lorsque ledit module de plateau de ventilateur est retiré (OUT) de ladite armoire électronique (EC).

3. Dispositif destiné à empêcher la recirculation selon la revendication 1, ***caractérisé en ce que*** ledit dispositif destiné à empêcher la recirculation (ARC) comprend en outre une chambre de stockage de store à enroulement (RC) dotée d'un mécanisme axial à ressort (SM) adapté pour rentrer et enrouler ledit store à enroulement (BL) dans ladite chambre de stockage de store à enroulement (RC).

4. Dispositif destiné à empêcher la recirculation selon la revendication 3, ***caractérisé en ce que*** ledit mécanisme axial à ressort (SM) est adapté pour rentrer ledit store à enroulement (BL) dans ladite chambre de stockage de store à enroulement (RC) lorsque ladite barre terminale de store (BE) est connectée audit bord arrière (RE) et lorsque ledit module de plateau de ventilateur (FM) est inséré (IN) dans ladite armoire électronique (EC) en coulissant le long desdits rails de guidage de ventilateur (FG).

5. Dispositif destiné à empêcher la recirculation selon la revendication 1, ***caractérisé en ce que*** ladite barre terminale de store (BE) comprend des crochets d'un premier type (HK1) adaptés pour venir en prise avec des orifices prévus sur des premières prises (TP1) audit bord arrière (RE) pour connecter ladite barre terminale de store (BE) audit module de plateau de ventilateur (FM).

6. Dispositif destiné à empêcher la recirculation selon la revendication **5**,
***caractérisé en ce que** ladite* barre terminale de store (BE) comprend au moins un crochet d'un deuxième type (HK2) et adapté pour venir en prise avec un orifice (HL2) prévu sur le châssis (CH) de ladite armoire électronique (EC),
***et en ce que*** ledit bord arrière (RE) est en outre doté d'au moins une deuxième prise (TP2) adaptée pour libérer dudit châssis (CH) ledit crochet d'un deuxième type (HK2).

7. Dispositif destiné à empêcher la recirculation selon la revendication **1**, ***caractérisé en ce que*** ledit module de plateau de ventilateur (FM) comprend une pluralité de ventilateurs, chacun étant doté d'un moteur de ventilateur et adapté pour forcer ledit flux d'air sortant (AF) vers ladite sortie d'air (AO).

8. Dispositif destiné à empêcher la recirculation selon la revendication **7**, ***caractérisé en ce que*** chaque ventilateur de ladite pluralité est doté de déflecteurs pour empêcher la circulation de l'air lorsque ledit ventilateur n'est pas activé.

9. Dispositif destiné à empêcher la recirculation selon la revendication **1**, ***caractérisé en ce que*** ladite armoire électronique (EC) comprend une pluralité de modules de plateau de ventilateur (FM ; FM2).

10. Dispositif destiné à empêcher la recirculation selon la revendication **1**, ***caractérisé en ce que*** lesdits rails de guidage de store (BG) sont lesdits rails de guidage de ventilateur (FG).
